# EUROPÄISCHE PATENTSCHRIFT

(11) **EP 1 761 547 B1**
(45) Veröffentlichungstag und Bekanntmachung des Hinweises auf die Patenterteilung: **27.07.2011**
(21) Anmeldenummer: 05756091.4
(22) Anmeldetag: 22.06.2005
(51) Int. Cl.: C07F 9/02

(54) **VERBINDUNGEN FÜR ORGANISCHE ELEKTRONISCHE VORRICHTUNGEN**
COMPOUNDS FOR ORGANIC ELECTRONIC DEVICES
COMPOSES POUR DISPOSITIFS ELECTRONIQUES ORGANIQUES

(30) Priorität: 26.06.2004 DE 102004031000; 01.12.2004 EP 04028407; 31.01.2005 EP 05001891; 03.05.2005 EP 05009644
(43) Veröffentlichungstag der Anmeldung: 14.03.2007
(73) Patentinhaber: Merck Patent GmbH, 64293 Darmstadt (DE)
(72) Erfinder: STÖSSEL, Phillipp, 60487 Frankfurt (DE); VESTWEBER, Horst, 34630 Gilserberg (DE); HEIL, Holger, 64285 Darmstadt (DE); BREUNING, Esther, 65527 Niedernhausen (DE)
(86) Internationale Anmeldenummer: PCT/EP2005/006729
(87) Internationale Veröffentlichungsnummer: WO 2006/000390

(56) Entgegenhaltungen:
- JP-A- 2004 095 221
- PADMAPERUMA A B ET AL: "NEW DENDRITIC MATERIALS AS POTENTIAL OLED TRANSPORT AND EMITTER MOIETIES" MATERIALS RESEARCH SOCIETY SYMPOSIUM PROCEEDINGS, MATERIALS RESEARCH SOCIETY, PITTSBURG, PA, US, Bd. 621, 2000, Seiten Q3901-Q3916, XP009050545 ISSN: 0272-9172
- WANG Y ET AL: "Ultrafast Fluorescence Investigation of Excitation Energy Transfer in Different Dendritic Core Branched Structures" JOURNAL OF THE AMERICAN CHEMICAL SOCIETY, AMERICAN CHEMICAL SOCIETY, WASHINGTON, DC, US, Bd. 125, 2003, Seiten 9562-9563, XP002335914 ISSN: 0002-7863
- PATENT ABSTRACTS OF JAPAN Bd. 2003, Nr. 12, 5. Dezember 2003 (2003-12-05) & JP 2004 095221 A (TORAY IND INC), 25. März 2004 (2004-03-25)

## Beschreibung

Die vorliegende Erfindung beschreibt neue Verbindungen und deren Einsatz in organischen Elektrolumineszenzvorrichtungen.

Der Einsatz halbleitender organischer Verbindungen, die zur Emission von Licht im sichtbaren Spektralbereich befähigt sind, in organischen Elektrolumineszenzvorrichtungen (OLEDs) steht gerade am Anfang der Markteinführung. Der allgemeine Aufbau derartiger Vorrichtungen ist beispielsweise in US 4539507, US 5151629, EP 0676461 und WO 98/27136 beschrieben. Für einfache OLEDs enthaltende Vorrichtungen ist die Markteinführung bereits erfolgt, wie die Autoradios der Firma Pioneer, die Mobiltelefone der Firmen Pioneer und SNMD oder eine Digitalkamera der Firma Kodak mit "organischem Display" belegen. Weitere derartige Produkte stehen kurz vor der Einführung.

Allerdings zeigen diese Vorrichtungen immer noch erhebliche Probleme, die einer dringenden Verbesserung bedürfen:
1. Die Effizienz ist gerade bei fluoreszierenden OLEDs immer noch zu niedrig und muss verbessert werden.
2. Die operative Lebensdauer ist insbesondere bei blauer Emission immer noch gering, so dass bis dato nur einfache Anwendungen kommerziell realisiert werden konnten.
3. Stilbenamine, die gemäß dem Stand der Technik als blau emittierende Dotanden verwendet werden, zeigen im Allgemeinen nur eine hellblaue, aber keine tiefblaue Emission. Insbesondere für die Herstellung großformatiger Vollfarbdisplays wird jedoch tiefblaue Emission benötigt.
4. Viele blau emittierende Emitter, die sowohl aromatische Amine, wie auch Doppelbindungssysteme enthalten, sind thermisch nicht stabil und zersetzen sich beim Sublimieren oder beim Aufdampfen. Dadurch ist die Verwendung dieser Systeme nicht bzw. nur unter großen Verlusten und mit hohem technischen Aufwand möglich.

Als nächstliegender Stand der Technik kann die Verwendung bestimmter Arylvinylamine von Idemitsu genannt werden (z. B. WO 04/013073, WO 04/016575, WO 04/018587). Damit werden sehr gute Lebensdauern bei tiefblauer Emission zitiert. Allerdings sind diese Ergebnisse, wie man sieht, stark abhängig vom verwendeten Hostmaterial, so dass die zitierten Lebensdauern nicht als Absolutwerte verglichen werden können, sondern immer nur bei Einsatz in einem optimierten System. Weiterhin sind diese Verbindungen thermisch instabil und lassen sich nicht unzersetzt verdampfen, was daher einen hohen technischen Aufwand für die Aufdampfung erfordert und somit einen deutlichen technischen Nachteil darstellt. Einen weiteren Nachteil stellt die Emissionsfarbe dieser Verbindungen dar. Während Idemitsu tiefblaue Emission (CIE-y-Koordinaten im Bereich von 0.15-0.18) zitiert, konnten diese Farbkoordinaten nicht in einfachen Vorrichtungen gemäß dem Stand der Technik reproduziert werden. Im Gegenteil erhält man hier grünblaue Emission. Es ist nicht offensichtlich, wie mit diesen Verbindungen tatsächlich blaue Emission erzeugt werden kann.

A. B. Padmaperuma et al. (Mat. Res. Soc. Symp. Proc. Vol. 621, 2000, Q3901-Q3906) beschreiben die Verwendung einer Trisstilbenphosphin- sowie einer Trisstilbenamin-Verbindung als Lochtransportmaterial in organischen Elektrolumineszenzvorrichtungen.

Weiterhin offenbart Y. Wang et al. (J. Am. Chem. Soc. 2003, 125, 9562-9563) ein Trisstyrylphosphinderivat, in welchem die Styrylgruppen jeweils mit einer weiteren Styrylgruppe substituiert sind. In der Publikation werden fluoreszenzspektroskopische Untersuchungen an der Verbindung beschrieben, die Verwendung der Verbindung in einer elektronischen Vorrichtung wird jedoch nicht offenbart.

In JP 2004-095221 werden schließlich organische Elektrolumineszenzvorrichtungen offenbart, welche Phosphinoxidderivate in einer Elektronentransportschicht enthalten. Einige der beispielhaft aufgeführten Phosphinoxidderivate weisen Styrylgruppen auf. Es wird jedoch nicht offenbart, dass diese Verbindungen sich als emittierende Materialien zur Verwendung in organischen Elektrolumineszenzvorrichtungen eignen.

Es besteht also weiterhin ein Bedarf an blau emittierenden Verbindungen, die in organischen Elektrolumineszenzvorrichtungen zu guten Effizienzen und gleichzeitig zu hohen Lebensdauern führen und die technisch unproblematisch zu verarbeiten sind.

Es wurde nun überraschend gefunden, dass organische Elektrolumineszenzvorrichtungen, die bestimmte - im Folgenden aufgeführte - Verbindungen als blau emittierende Dotanden, vorzugsweise in einem Hostmaterial, enthalten, deutliche Verbesserungen gegenüber dem Stand der Technik aufweisen. Mit diesen Materialien ist es möglich, längere Lebensdauern bei höherer Effizienz zu erhalten. Außerdem lassen sich diese Verbindungen im Gegensatz zu Materialien gemäß dem Stand der Technik ohne merkliche Zersetzung sublimieren und aufdampfen und sind daher deutlich leichter zu handhaben als Materialien gemäß dem Stand der Technik. Diese Verbindungen und deren Verwendung in OLEDs sind daher Gegenstand der vorliegenden Erfindung.

Gegenstand der Erfindung ist die Verwendung von Verbindungen gemäß Formel (1), 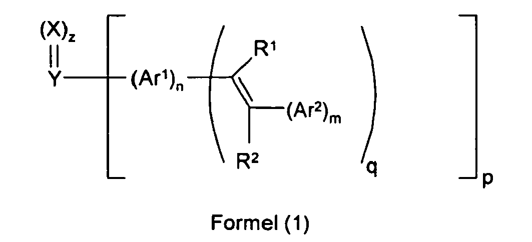 wobei für die verwendeten Symbole und Indizes gilt:
- Y: ist bei jedem Auftreten Phosphor;

- X: ist bei jedem Auftreten gleich oder verschieden Sauerstoff, Schwefel, oder steht für ein freies Elektronenpaar;
- Ar¹: ist bei jedem Auftreten gleich oder verschieden eine Arylgruppe mit 6 bis 16 C-Atomen oder eine Heteroarylgruppe mit 2 bis 16 C-Atomen, die mit einem oder zwei Resten R¹⁰ substituiert sein kann;
- Ar²: ist bei jedem Auftreten gleich oder verschieden eine Arylgruppe mit 6 bis 16 C-Atomen oder eine Heteroarylgruppe mit 2 bis 16 C-Atomen, die mit einem oder zwei Resten R¹⁰ substituiert sein kann;
- R¹, R²: ist bei jedem Auftreten gleich oder verschieden H, CN, eine geradkettige Alkylgruppe mit 1 bis 20 C-Atomen oder eine verzweigte Alkylgruppe mit 3 bis 20 C-Atomen, wobei eine oder mehrere nicht benachbarte CH₂-Gruppen durch -R²⁰C=CR²⁰-, -C≡C-, -O- oder -S- ersetzt sein können und wobei ein oder mehrere H-Atome durch F ersetzt sein können, oder eine Arylgruppe mit 6 bis 16 C-Atomen oder Heteroarylgruppe mit 2 bis 16 C-Atomen, die mit einem oder mehreren Resten R¹⁰ substituiert sein kann, wobei R¹ bzw. R² jeweils unabhängig voneinander mit dem Rest Ar¹ und/oder Ar² gemeinsam ein cyclisches System bilden können ;
- R¹⁰: ist bei jedem Auftreten gleich oder verschieden H, F, CN, eine geradkettige Alkyl- oder Alkoxygruppe mit 1 bis 20 C-Atomen, eine verzweigte Alkyl- oder Alkoxygruppe mit 3 bis 20 C-Atomen, eine cyclische Alkyl- oder Alkoxygruppe mit 5 bis 20 C-Atomen, die jeweils mit einem oder mehreren Resten R²⁰ substituiert sein können, wobei eine oder mehrere nicht benachbarte CH₂- Gruppen durch -R²⁰C=CR²⁰-, -C≡C-, Si(R²⁰)₂, C=O, -O- oder -S- ersetzt sein können und wobei ein oder mehrere H-Atome durch F ersetzt sein können, oder eine Arylgruppe mit 6 bis 16 C-Atomen oder Heteroarylgruppe mit 2 bis 16 C- Atomen, die jeweils durch einen oder mehrere Reste R²⁰ substituiert sein kann, oder eine Aryloxy- oder Heteroaryloxygruppe mit 2 bis 16 aromatischen C- Atomen, die durch einen oder mehrere Reste R²⁰ substituiert sein kann, oder eine Kombination aus zwei, drei, vier oder fünf dieser Systeme; dabei können auch zwei oder mehrere Substituenten R¹⁰ sowohl am selben Ring wie auch an unterschiedlichen Ringen miteinander ein mono- oder polycyclisches, aliphatisches oder aromatisches Ringsystem bilden oder zusammen mit einem Rest R¹ und/oder R² ein Ringsystem bilden

- R²⁰: ist bei jedem Auftreten gleich oder verschieden H oder ein aliphatischer oder aromatischer Kohlenwasserstoffrest mit 1 bis 20 C-Atomen;
- n: ist bei jedem Auftreten gleich oder verschieden und steht für eine ganze Zahl 1, 2 oder 3;
- m: ist bei jedem Auftreten gleich oder verschieden und steht für eine ganze Zahl 1;
- q: ist bei jedem Auftreten gleich oder verschieden und steht für eine ganze Zahl 1, 2, 3, 4 oder 5;
- p: steht für die ganze Zahl 3,
- z: ist die ganze Zahl 1; ausgenommen die Verbindung 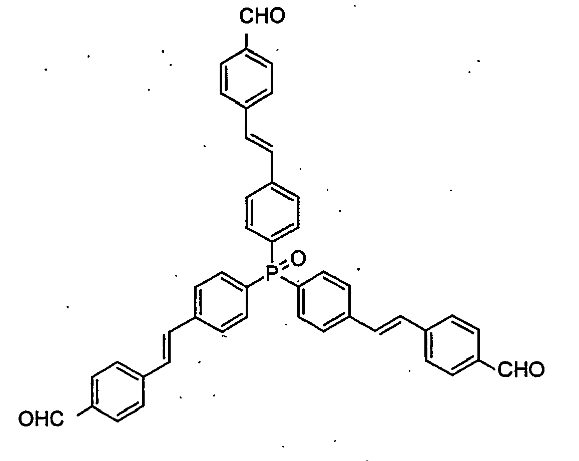
in elektronischen Vorrichtungen, insbesondere in organischen Leuchtdioden (O-LEDs), organischen Feld-Effekt-Transistoren (O-FETs), organischen lichtemittierenden Transistoren (O-LETs), organischen Dünnfilmtransistoren (O-TFTs), organischen integrierten Schaltungen (O-ICs), organischen Solarzellen (O-SCs), organischen Feld-Quench-Devices (O-FQDs) oder organischen Laserdioden (O-Laser), besonders bevorzugt in organischen Leuchtdioden (O-LEDs).

Unter einer Arylgruppe bzw. einer Heteroarylgruppe im Sinne dieser Erfindung wird eine aromatische Gruppe bzw. heteroaromatische Gruppe mit einem gemeinsamen aromatischen Elektronensystem verstanden. Dies kann im Sinne dieser Erfindung ein einfacher Homo- oder Heterocyclus sein, beispielsweise Benzol, Pyridin, Thiophen, etc., oder es kann ein kondensiertes aromatisches Ringsystem sein, in dem mindestens zwei aromatische oder heteroaromatische Ringe, beispielsweise Benzolringe, miteinander "verschmolzen", d. h. durch Anellierung einander ankondensiert sind, also mindestens eine gemeinsame Kante und dadurch auch ein gemeinsames aromatisches System aufweisen. So sind beispielsweise Systeme wie Naphthalin, Anthracen, Phenanthren, Pyren, etc. als Arylgruppen und Chinolin, Acridin, Benzothiophen, Carbazol, etc. als Heteroarylgruppen im Sinne dieser Erfindung zu sehen, während beispielsweise Biphenyl, Fluoren, Spirobifluoren, etc. keine Arylgruppen darstellen, da es sich hierbei um separate aromatische Elektronensysteme handelt.

Im Rahmen der vorliegenden Erfindung werden unter einer Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einer Aryl- oder Heteroarylgruppe, die je nach Verwendung monovalent oder bivalent sein kann, die noch jeweils mit den oben genannten Resten R¹⁰ substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Chrysen, Perylen, Fluoranthen, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Die durch Kombination dieser Systeme und Bildung zusätzlicher Ringsysteme entstehenden Systeme sind bevorzugt Biphenylen, Terphenylen, Fluoren, Spirobifluoren, Dihydrophenanthren, Dihydropyren, Tetrahydropyren oder cis- oder trans-Indenofluoren.

Bevorzugt sind Verbindungen gemäß Formel (1), in denen das Symbol X für Sauerstoff oder ein freies Elektronenpaar steht.

Ganz besonders bevorzugt sind Verbindungen der Formel (1), bei denen für den Fall, dass der Rest Y für Phosphor, X für ein freies Elektronenpaar, Ar¹ für Phenyl, n und q gleich 1, p gleich 3, R¹ und R² für Wasserstoff und Ar² für einen mit einem Rest R¹⁰ substituierten Phenylrest steht, der Rest R¹⁰ nicht für NPh₂ steht. Der Rest Ph steht für einen unsubstituierten Phenylrest.

Ganz besonders bevorzugt sind Verbindungen der Formel (1), bei denen für den Fall, dass der Rest Y für Phosphor, X für Sauerstoff, Ar¹ für Phenyl, n und q gleich 1, p gleich 3, R¹ und R² für Wasserstoff und Ar² für ein mit einem Rest R¹⁰ substituierten Phenylrest steht, der Rest R¹⁰ nicht für CHO steht.

Bevorzugt sind weiterhin Verbindungen gemäß Formel (1), in denen die Symbole Ar¹ und Ar² gleich oder verschieden bei jedem Auftreten für eine Arylgruppe mit 6 bis 14 C-Atomen oder eine Heteroarylgruppe mit 4 bis 14 C-Atomen, die jeweils mit einem oder zwei Resten R¹⁰ substituiert sein können, stehen, besonders bevorzugt für eine Aryl- oder Heteroarylgruppe, ausgewählt aus Benzol, Naphthalin, Anthracen, Phenanthren, Pyridin und Thiophen, insbesondere Benzol, die jeweils mit einem oder zwei Resten R¹⁰ substituiert sein kann.

Besonders bevorzugt stehen die Symbole R¹ und R² für H, CN, Methyl, Ethyl, Propyl, i- Propyl, n-, sek- oder tert-Butyl, oder eine Phenylgruppe oder eine Heteroarylgruppe mit 4 bis 6 C-Atomen, die mit einem oder mehreren Resten R¹⁰ substituiert sein kann, und/oder R¹ bzw. R² bilden jeweils unabhängig voneinander mit dem Rest Ar¹ und/oder Ar² gemeinsam ein cyclisches System. Ganz besonders bevorzugt stehen die Symbole R¹ und R² für H.

Bevorzugt sind weiterhin Verbindungen gemäß Formel (1), in denen die Symbole Ar¹ und Ar² gleich oder verschieden bei jedem Auftreten für eine Phenylgruppe oder eine Heteroarylgruppe mit 4 bis 6 C-Atomen stehen, und R¹ und R² gleich oder verschieden bei jedem Auftreten ausgewählt sind aus H, einer geradkettigen Alkylgruppe mit 1 bis 10 C-Atomen und einer verzweigten Alkylgruppe mit 3 bis 4 C-Atomen, wobei eine oder mehrere nicht benachbarte CH₂-Gruppen durch -O- oder -S- ersetzt sein können und wobei ein oder mehrere H-Atome durch F ersetzt sein können, und der Rest R¹⁰ bei jedem Auftreten gleich oder verschieden ausgewählt ist aus H, F, Br, CN, einer geradkettigen Alkylgruppe mit 1 bis 10 C-Atomen, wobei bei der vorstehend genannten Alkylgruppe unabhängig voneinander eine oder mehrere nicht benachbarte CH₂-Gruppen durch -O- oder -S- ersetzt sein können und wobei ein oder mehrere H-Atome durch F, Cl, Br, I, CN oder NO₂ ersetzt sein können, und einer Arylgruppe mit 6 bis 14 C-Atomen, insbesondere Benzol, Naphthalin, Anthracen und Phenanthren, und einer Heteroarylgruppe mit 2 bis 10 C-Atomen, insbesondere Pyridin und Thiophen, welche jeweils durch einen oder mehrere Reste R²⁰ substituiert sein können, und einer Aryloxygruppe mit 6 bis 10 aromatischen C-Atomen oder einer Heteroaryloxygruppe mit 2 bis 10 aromatischen C-Atomen, die jeweils durch einen oder mehrere Reste R²⁰ substituiert sein können.

Besonders bevorzugt ist der Rest R¹⁰ am Rest Ar² gebunden, insbesondere in ortho-oder para-Position, ganz besonders bevorzugt in der para-Position.

Bevorzugt sind weiterhin Verbindungen, in denen der Index für 1 oder 2, ganz besonders bevorzugt für 1 steht.

Bevorzugt sind weiterhin Verbindungen, in denen der Index q gleich oder verschieden bei jedem Auftreten für 1, 2 oder 3 steht, besonders bevorzugt für 1 oder 2, ganz besonders bevorzugt für 1.

Die Aryl- bzw. Heteroarylgruppen Ar¹ - und im Falle eines Ar², das mit einen Arylrest (R¹⁰) substituiert ist - weisen vorzugsweise eine gerade Anzahl aromatischer Ringatome zwischen den beiden Verknüpfungsstellen auf. Insbesondere der Rest Ar¹ und auch der der vorstehend genannte Rest Ar² weisen eine durch vier teilbare Anzahl an Ringatomen auf. So ist beispielsweise für Phenylensysteme die ortho- und die para-Verknüpfung bevorzugt, insbesondere die para-Verknüpfung.

Besonders bevorzugt sind Verbindungen gemäß Formel (1), die symmetrisch aufgebaut sind und eine dreizählige Drehachse aufweisen, was sich nicht nur auf die aromatischen Gruppen Ar¹ und Ar² bezieht, sondern besonders bevorzugt auch auf die Reste R¹ und R². Diese Bevorzugung ist durch die leichtere synthetische Zugänglichkeit der Verbindungen zu begründen. Jedoch auch die unsymmetrischen Verbindungen sind in mehr Stufen zugänglich.

Wenn die Verbindung Atropisomerie um eine oder um mehrere Bindungen zeigen kann, so sind jeweils auch die isolierten oder angereicherten Atropisomere Gegenstand der Erfindung. Dies bezieht sich sowohl auf Enantiomere wie auch auf Diastereomere. Durch die Wahl geeigneter Atropisomere lässt sich beispielsweise die Löslichkeit der Verbindung beeinflussen.

Beispiele für bevorzugte Verbindungen gemäß Formel (1) sind die im Folgenden abgebildeten Beispiele 1 bis 34.

| | | |
|---|---|---|
| 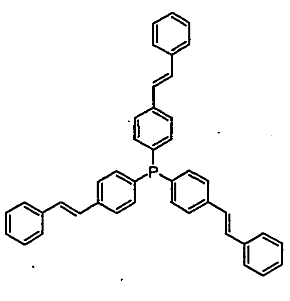 | 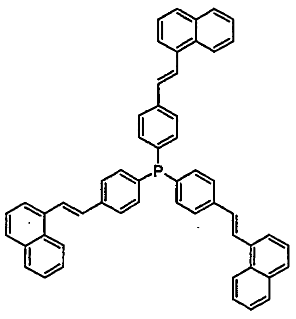 | 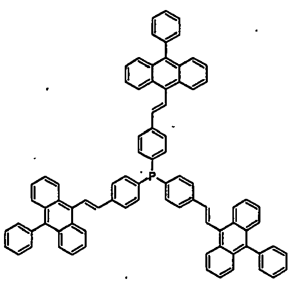 |
| Beispiel 1 | - Beispiel 2 | Beispiel 3 |
| 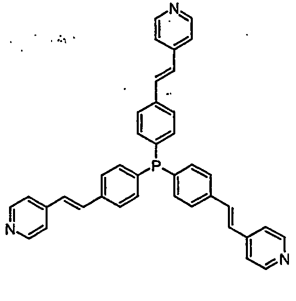 | 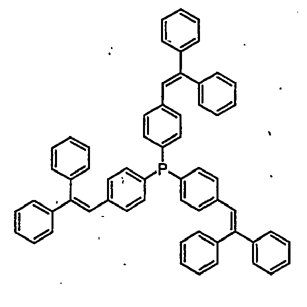 | 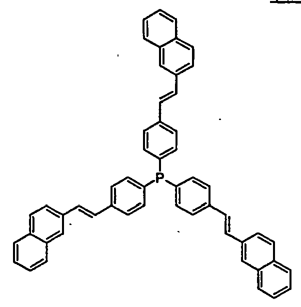 |
| Beispiel 4 | Beispiel 5 | Beispiel 6 |
| 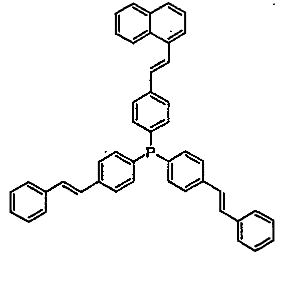 | 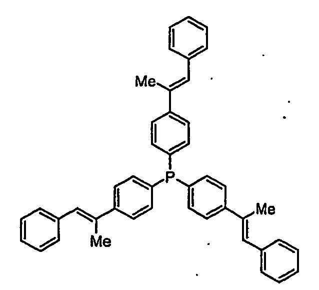 | 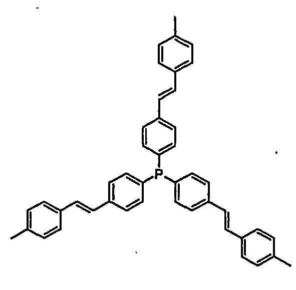 |
| Beispiel 7 | Beispiel 8 | Beispiel 9 |
| 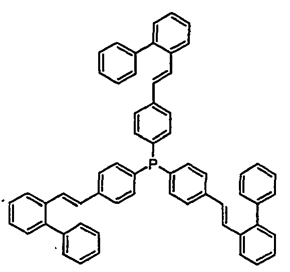 | 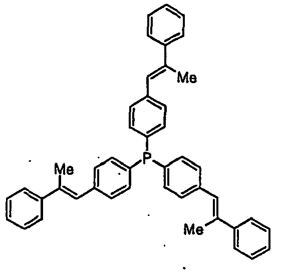 | 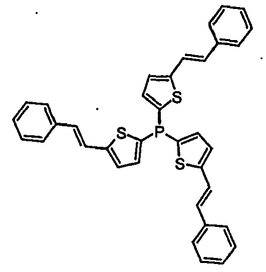 |
| Beispiel 10 | Bespiel 11 | Beispiel 12 |
| 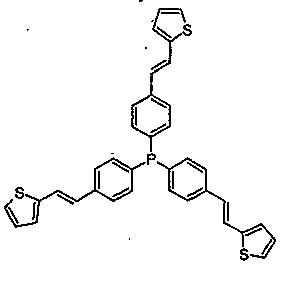 | 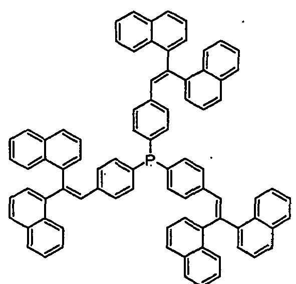 | 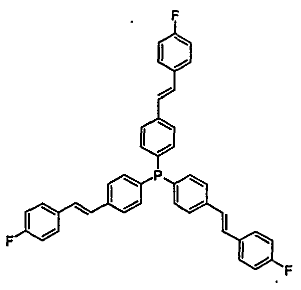 |
| Beispiel 13 | Beispiel 14 | Beispiel 15 |
| 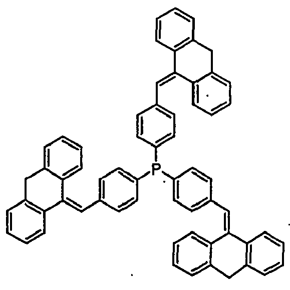 | 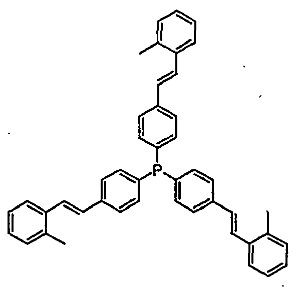 | 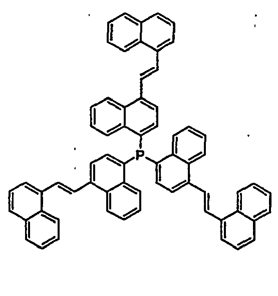 |
| Beispiel 16 | Beispiel 17 | Beispiel 18 |
| 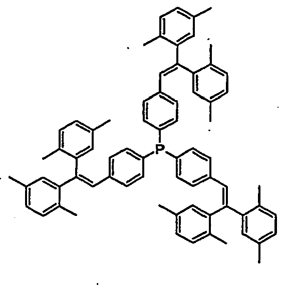 | 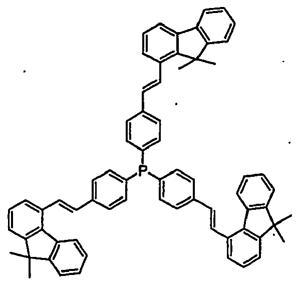 | 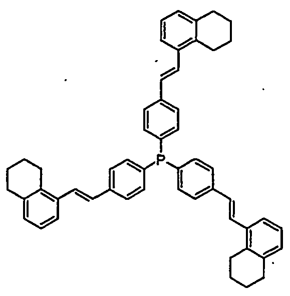 |
| Beispiel 19 | Beispiel 20 | Beispiel 21 |
| 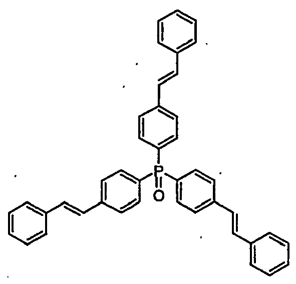 | 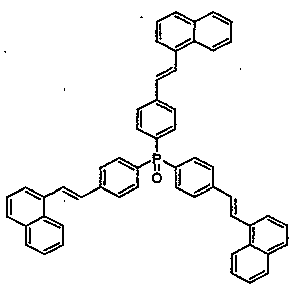 | 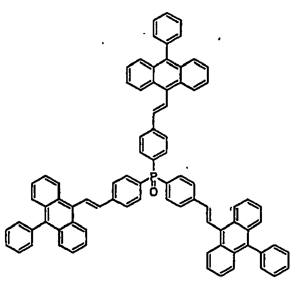 |
| Beispiel 22 | Beispiel 23 | Beispiel 24 |
| 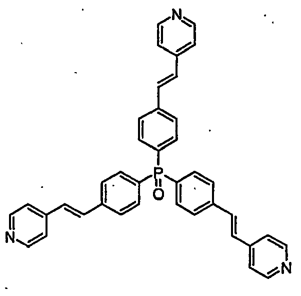 | 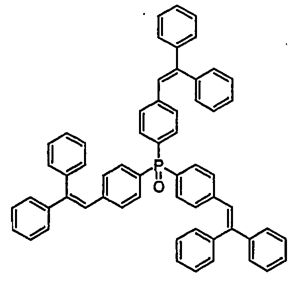 | 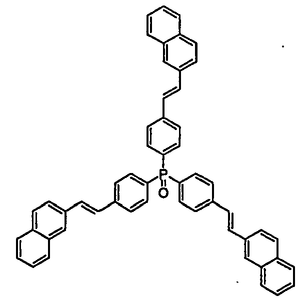 |
| Beispiel 25 | Beispiel 26 | Beispiel 27 |
| 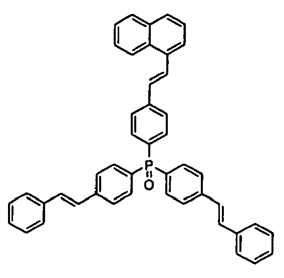 | 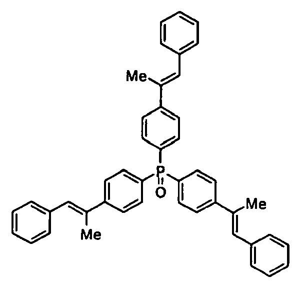 | 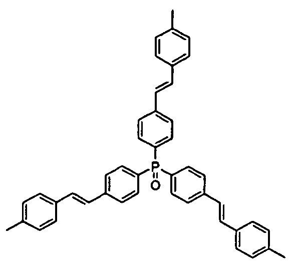 |
| Beispiel 28 | Beispiel 29 | Beispiel 30 |
| 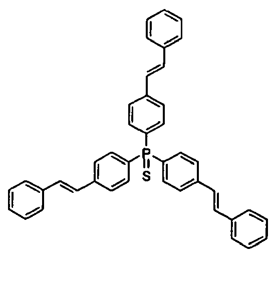 | 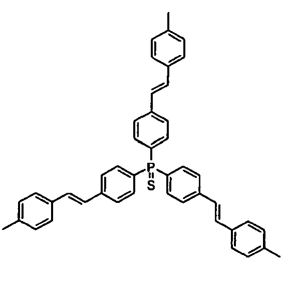 | 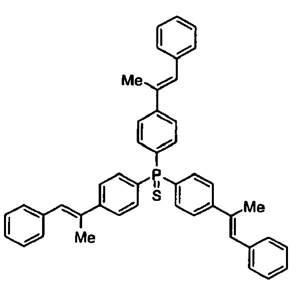 |
| Beispiel 31 | Beispiel 32 | Beispiel 33 |
| | | 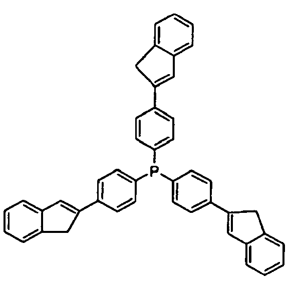 |
| | | Beispiel 34 |

Die erfindungsgemäßen Verbindungen können nach dem Fachmann bekannten Syntheseschritten, wie z. B. Bromierung, Suzuki-Kupplung, Wittig-Horner-Reaktion, etc., dargestellt werden. Triarylphosphine lassen sich beispielsweise leicht durch Salzmetathese aus Metallaryl-Verbindungen (beispielsweise Aryllithium-Verbindungen oder Aryl-Grignard-Verbindungen) durch Reaktion mit Phosphortrihalogeniden synthetisieren. Die Bromierung dieser Triarylphosphinen führt zu Tris-p-brom-substituierten Triarylphosphinen, wobei hier - bedingt durch den +M-dirigierenden Effekt des Phosphoratoms - häufig sehr gute Ausbeuten bei exzellenten Regioselektivitäten erreicht werden. Als Bromierungsagens können neben elementarem Brom vor allen auch N-Brom-Verbindungen wie N-Bromsuccinimid (NBS) verwendet werden. Die so dargestellten Tris-p-brom-substituierten Triarylphosphine lassen leicht z. B. durch Suzuki-Kupplung unter Standardbedingungen mit funktionalisierten Arylboronsäuren in ausgezeichneten Ausbeuten umsetzen. Als Funktionalisierung kommen insbesondere Formyl-, Alkylcarbonyl- und Arylcarbonyl-Gruppen oder deren geschützte Analoga, z. B. in Form der entsprechenden Dioxolane, in Frage. Weiterhin lassen sich die Tris-p-brom-substituierten Triarylphosphine beispielsweise durch Vielsmeyer-Formylierung mit Aldehyd-Gruppen funktionalisieren und können so als Edukte für Wittig-Horner-Reaktionen eingesetzt werden. Selbstverständlich können auch andere Kupplungsreaktionen (z. B. Stille-Kupplung, Heck-Kupplung, etc.) Verwendung finden. Die so erhaltenen Carbonyl-Substrate können dann leicht, z. B. durch eine Wittig-Horner-Reaktion, in die entsprechenden Olefine überführt werden. Entsprechende Phosphinoxide sind durch Oxidation der Phosphine, beispielsweise mit Wasserstoffperoxid, zugänglich.

Gegenstand der Erfindung sind weiterhin konjugierte, teilkonjugierte oder nicht-konjugierte Polymere, Oligomere oder Dendrimere, enthaltend Wiederholeinheiten gemäß Formel (1). Diese Wiederholeinheiten können beispielsweise in Polyfluorene (z. B. gemäß EP 842208 oder WO 00/22026), Poly-spirobifluorene (z. B. gemäß EP 707020, EP 894107 oder EP 04028865.6), Poly-para-phenylene (z. B. gemäß WO 92/18552), Poly-dihydrophenanthrene (z. B. gemäß WO 05/014689), Polyphenanthrene (z. B. gemäß DE 102004020298.2), Poly-indenofluorene (z. B. gemäß WO 04/041901 oder WO 04/113412), Poly-carbazole (z. B. gemäß WO 04/070772 oder WO 04/113468), Poly-anthracene, Poly-naphthaline (z. B. gemäß EP 04030093.1) oder Polythiophene (z. B. gemäß EP 1028136) einpolymerisiert werden. Auch Polymere mit mehreren dieser Einheiten oder Homopolymere der Wiederholeinheiten gemäß Formel (1) sind möglich. Ebenso Gegenstand der vorliegenden Erfindung ist die Verwendung dieser Polymere, Oligomere oder Dendrimere in organischen elektronischen Vorrichtungen.

Die Verbindungen gemäß Formel (1) können in organischen Elektrolumineszenzvorrichtungen eingesetzt werden. Dabei wird die Verbindung bevorzugt in der emittierenden Schicht und vorzugsweise als Mischung mit mindestens einem Hostmaterial eingesetzt. Es ist bevorzugt, wenn die Verbindung gemäß Formel (1) in der Mischung die emittierende Verbindung (der Dotand) ist. Bevorzugte Hostmaterialien sind organische Verbindungen, deren Emission kürzerwellig ist als die der Verbindung gemäß Formel (1) oder die überhaupt nicht im sichtbaren Bereich emittieren. Auch die Verwendung der Verbindungen gemäß Formel (1) als Lochtransportmaterial ist möglich.

Ein weiterer Gegenstand der vorliegenden Erfindung sind Mischungen enthaltend mindestens eine Verbindung gemäß Formel (1), 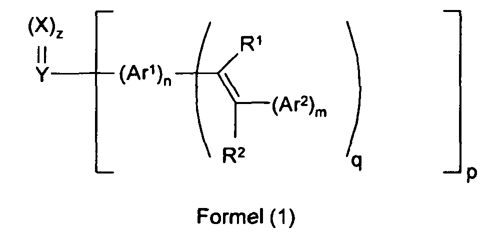 wobei für die verwendeten Symbole und Indizes gilt:
- Y: ist bei jedem Auftreten Phosphor;
- X: ist bei jedem Auftreten gleich oder verschieden Sauerstoff, Schwefel oder steht für ein freies Elektronenpaar;
- Ar¹: ist bei jedem Auftreten gleich oder verschieden eine Arylgruppe mit 6 bis 16 C-Atomen oder eine Heteroarylgruppe mit 2 bis 16 C-Atomen, die mit einem oder zwei Resten R¹⁰ substituiert sein kann;
- Ar²: ist bei jedem Auftreten gleich oder verschieden eine Arylgruppe mit 6 bis 16 C-Atomen oder eine Heteroarylgruppe mit 2 bis 16 C-Atomen, die mit einem oder zwei Resten R¹⁰ substituiert sein kann;
- R¹, R²: ist bei jedem Auftreten gleich oder verschieden H, CN, eine geradkettige Alkylgruppe mit 1 bis 20 C-Atomen oder eine verzweigte Alkylgruppe mit 3 bis 20 C-Atomen, wobei eine oder mehrere nicht benachbarte CH₂-Gruppen durch -R²⁰C=CR²⁰-, -C=C-, -O- oder -S- ersetzt sein können und wobei ein oder mehrere H-Atome durch F ersetzt sein können, oder eine Arylgruppe mit 6 bis 16 C-Atomen oder Heteroarylgruppe mit 2 bis 16 C-Atomen, die mit einem oder mehreren Resten R¹⁰ substituiert sein kann, wobei R¹ bzw. R² jeweils unabhängig voneinander mit dem Rest Ar¹ und/oder Ar² gemeinsam ein cyclisches System bilden könne;

- R¹⁰: ist bei jedem Auftreten gleich oder verschieden H, F, CN, eine geradkettige Alkyl- oder Alkoxygruppe mit 1 bis 20 C-Atomen, eine verzweigte Alkyl- oder Alkoxygruppe mit 3 bis 20 C-Atomen, eine cyclische Alkyl- oder Alkoxygruppe mit 5 bis 20 C-Atomen, die jeweils mit einem oder mehreren Resten R²⁰ substituiert sein können, wobei eine oder mehrere nicht benachbarte CH₂- Gruppen durch -R²⁰C=CR²⁰-, -C≡C-, Si(R²⁰)₂, C=O, -O- oder -S- ersetzt sein können und wobei ein oder mehrere H-Atome durch F ersetzt sein können, oder eine Arylgruppe mit 6 bis 16 C-Atomen oder Heteroarylgruppe mit 2 bis 16 C- Atomen, die jeweils durch einen oder mehrere Reste R²⁰ substituiert sein kann, oder eine Aryloxy- oder Heteroaryloxygruppe mit 2 bis 16 aromatischen C- Atomen, die durch einen oder mehrere Reste R²⁰ substituiert sein kann, oder eine Kombination aus zwei, drei, vier oder fünf dieser Systeme; dabei können auch zwei oder mehrere Substituenten R¹⁰ sowohl am selben Ring wie auch an unterschiedlichen Ringen miteinander ein mono- oder polycyclisches, aliphatisches oder aromatisches Ringsystem bilden oder zusammen mit einem Rest R¹ und/oder R² ein Ringsystem bilden;
- R²⁰: ist bei jedem Auftreten gleich oder verschieden H oder ein aliphatischer oder aromatischer Kohlenwasserstoffrest mit 1 bis 20 C-Atomen;
- n: ist bei jedem Auftreten gleich oder verschieden und steht für eine ganze Zahl 1, 2 oder 3;
- m: ist bei jedem Auftreten gleich oder verschieden und steht für eine ganze Zahl 1;
- q: ist bei jedem Auftreten gleich oder verschieden und steht für eine ganze Zahl 1, 2, 3, 4 oder 5;
- p: steht für die ganze Zahl 3,
- z: ist die ganze Zahl 1; und
mindestens ein Hostmaterial, welches ausgewählt ist aus Oligoarylenen, Oligoarylenvinylenen, polypodalen Metallkomplexen, Ketonen, Phosphinoxiden, Sulfoxiden oder Atropisomeren dieser Verbindungen.

Auf eine Wiederholung der vorstehend beschriebenen bevorzugten Ausführungsformen wird an dieser Stelle verzichtet. Sämtliche bevorzugte Ausführungsformen der Verbindungen der Formel (1) gelten auch für die erfindungsgemäße Mischung enthaltend mindestens eine Verbindung der Formel (1) und mindestens ein Hostmaterial.

Als Hostmaterialien kommen verschiedene Stoffklassen in Frage. Bevorzugte Hostmaterialien sind ausgewählt aus den Klassen der Oligo-arylene (z. B. 2,2',7,7'-tetraphenyl-spirobifluoren gemäß EP 676461 oder Dinaphthylanthracen), insbesondere der Oligo-arylene enthaltend kondensierte aromatische Gruppen, der Oligo-arylenvinylene (z. B. DPVBi oder Spiro-DPVBi gemäß EP 676461), der polypodalen Metallkomplexe (z. B. gemäß WO 04/081017), der lochleitenden Verbindungen (z. B. gemäß WO 04/058911), der elektronenleitenden Verbindungen, insbesondere Ketone, Phosphinoxide, Sulfoxide, etc. (z. B. gemäß der nicht offen gelegten Anmeldung DE 102004008304.5) oder der Atropisomere (z. B. gemäß der nicht offen gelegten Anmeldung EP 04026402.0). Besonders bevorzugte Hostmaterialien sind ausgewählt aus den Klassen der Oligoarylene, enthaltend Naphthalin, Anthracen und/oder Pyren oder Atropisomeren dieser Verbindungen, der Oligo-arylenvinylene, der Ketone, der Phosphinoxide und der Sulfoxide. Ganz besonders bevorzugte Hostmaterialien sind ausgewählt aus den Klassen der Oligoarylene, enthaltend Anthracen und/oder Pyren oder Atropisomeren dieser Verbindungen, der Phosphinoxide und der Sulfoxide.

Der Anteil der Verbindung gemäß Formel (1) in der Mischung beträgt zwischen 0.1 und 99.0 Gew.%, bevorzugt zwischen 0.5 und 50.0 Gew.%, besonders bevorzugt zwischen 1.0 und 20.0 Gew.%, insbesondere zwischen 1.0 und 10.0 Gew.%. Entsprechend beträgt der Anteil des Hostmaterials in der Mischung zwischen 1.0 und 99.9 Gew.%, bevorzugt zwischen 50.0 und 99.5 Gew.%, besonders bevorzugt zwischen 80.0 und 99.0 Gew.%, insbesondere zwischen 90.0 und 99.0 Gew.%.

Weiterhin bevorzugt sind organische Elektrolumineszenzvorrichtungen, dadurch gekennzeichnet, dass mehrere emittierende Verbindungen in derselben Schicht oder in unterschiedlichen Schichten verwendet werden, wobei mindestens eine dieser Verbindungen eine Struktur gemäß Formel (1) aufweist. Besonders bevorzugt weisen diese Verbindungen insgesamt mehrere Emissionsmaxima zwischen 380 nm und 750 nm auf, so dass insgesamt weiße Emission resultiert, d. h. außer der Verbindung gemäß Formel (1) wird noch mindestens eine weitere emittierende Verbindung verwendet, die fluoreszieren oder phosphoreszieren kann und die gelbes, orange oder rotes Licht emittiert. Insbesondere bevorzugt sind Dreischichtsysteme, wovon mindestens eine dieser Schichten eine Verbindung gemäß Formel (1) enthält und wobei die Schichten blaue, grüne und orange oder rote Emission zeigen (für den prinzipiellen Aufbau siehe z. B. WO 05/011013).

Außer Kathode, Anode und der emittierenden Schicht kann die organische Elektrolumineszenzvorrichtung noch weitere Schichten enthalten. Diese können beispielsweise sein: Lochinjektionsschicht, Lochtransportschicht, Elektronentransportschicht und/oder Elektroneninjektionsschicht. Es sei aber an dieser Stelle darauf hingewiesen, dass nicht notwendigerweise jede dieser Schichten vorhanden sein muss. So werden insbesondere bei Verwendung von Verbindungen gemäß Formel (1) mit elektronenleitenden Hostmaterialien weiterhin sehr gute Ergebnisse erhalten, wenn die organische Elektrolumineszenzvorrichtung keine separate Elektronentransportschicht enthält und die emittierende Schicht direkt an die Elektroneninjektionsschicht oder an die Kathode grenzt. Alternativ kann das Hostmaterial auch gleichzeitig in einer Elektronentransportschicht als Elektronentransportmaterial dienen. Ebenfalls kann es bevorzugt sein, wenn die organische Elektrolumineszenzvorrichtung keine separate Lochtransportschicht enthält und die emittierende Schicht direkt an die Lochinjektionsschicht oder an die Anode grenzt. Weiterhin kann es bevorzugt sein, wenn die Verbindung gemäß Formel (1) nicht oder nicht nur als Dotand in der emittierenden Schicht, sondern auch als lochleitende Verbindung (als Reinsubstanz oder als Mischung) in einer Lochtransportschicht verwendet wird.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen gemäß Formel (1) nötig. Hohe Löslichkeit lässt sich beispielsweise durch geeignete Substitution der Verbindungen erreichen.

Die erfindungsgemäßen Verbindungen weisen bei Verwendung in organischen Elektrolumineszenzvorrichtungen folgende überraschende Vorteile gegenüber dem Stand der Technik auf:
1. Die Effizienz entsprechender Vorrichtungen wird höher im Vergleich zu Systemen gemäß dem Stand der Technik.
2. Die Stabilität entsprechender Vorrichtungen wird höher im Vergleich zu Systemen gemäß dem Stand der Technik, was sich vor allem in einer deutlich höheren Lebensdauer zeigt.
3. In organischen Elektrolumineszenzvorrichtungen zeigen die Verbindungen gemäß Formel (1) eine deutlich tiefer blaue Emission als Stilbenamine gemäß dem Stand der Technik. Insbesondere für Vollfarb-Displays ist dies von entscheidender Bedeutung.
4. Die Verbindungen lassen sich gut und ohne erhebliche Zersetzung sublimieren und aufdampfen, sind dadurch leichter zu verarbeiten und deshalb besser für die Verwendung in OLEDs geeignet als Materialien gemäß dem Stand der Technik.

Ein weiterer Gegenstand der vorliegenden Erfindung ist somit eine elektrische Vorrichtung, vorzugsweise eine organische Elektrolumineszenzvorrichtung, die mindestens eine Schicht aufweist, die mindestens eine Verbindung der Formel (1) oder eine Mischung aus mindestens einer Verbindung der Formel (1) und mindestens einem Hostmaterial aufweist.

Im vorliegenden Anmeldetext und auch in den im Weiteren folgenden Beispielen wird auf die Verwendung erfindungsgemäßer Verbindungen in Bezug auf OLEDs und die entsprechenden Displays abgezielt. Trotz dieser Beschränkung der Beschreibung ist es für den Fachmann ohne weiteres erfinderisches Zutun möglich, die erfindungsgemäßen Verbindungen auch für weitere Verwendungen in anderen elektronischen Vorrichtungen zu benutzen, z. B. für organische Feld-Effekt-Transistoren (O-FETs), organische Dünnfilmtransistoren (O-TFTs), organische integrierte Schaltungen (O-ICs), organische Solarzellen (O-SCs) oder organische Laserdioden (O-Laser), um nur einige Anwendungen zu nennen.

Die Verwendung der erfindungsgemäßen Verbindungen in den entsprechenden Vorrichtungen ebenso wie diese Vorrichtungen selbst sind ebenfalls ein Gegenstand der vorliegenden Erfindung.

Die Erfindung wird durch die nachfolgenden Beispiele näher erläutert, ohne sie dadurch einschränken zu wollen.

### Beispiele:

Die nachfolgenden Synthesen wurden, sofern nicht anders angegeben, unter einer Schutzgasatmosphäre durchgeführt. Die Edukte wurden von den Firmen ALDRICH bzw. ABCR (Bis(4-bromphenyl)ether, 1,1-Diphenylethen, N,N-Dimethylglycin, Palladium(II)acetat, Anorganika, Lösemittel) bezogen. Tris(4-formylphenyl)phosphin wurde nach Chalier et al., J. Phys. Chem. 1996, 100(10), 4323 dargestellt.

### Beispiel 1: Synthese von Tris(4-stilbenyl)phosphin, Dotand D1

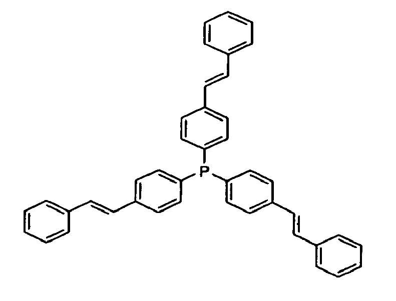

Ein Gemisch aus 50.0 ml (240 mmol) Phenylmethanphosphonsäurediethylester und 1000 ml DMF wurde unter gutem Rühren bei 0 °C mit 46.1 g (480 mmol) Natriumtert-butylat versetzt. Zu dieser Mischung wurde bei 0-10 °C eine 30 °C warme Lösung von 22.9 g (66 mmol) Tris(4-formylphenyl)phosphin in 1000 ml DMF langsam zugetropft. Nach vollendeter Zugabe wurde weitere 3 h bei 0 °C bis 10 °C und 12 h bei Raumtemperatur gerührt. Anschließend wurden 100 ml 2.5 N HCl, dann 300 ml Wasser und dann 300 ml Ethanol zugegeben. Der gelbe feinkristalline Niederschlag wurde abgesaugt (P3), dreimal mit je 200 ml eines Gemischs aus Ethanol / Wasser (1:1, v:v) und dreimal mit je 200 ml Ethanol gewaschen. Der Feststoff wurde nach Trocknen im Vakuum viermal unter Lichtausschluss aus DMF (ca. 3 ml/g) umkristallisiert. Nach zweimaligem Auskochen mit je 300 ml Ethanol und Trocknen des Feststoffs im Vakuum wurde dieser bei T = 320 °C, p = 5 x 10⁻⁵ mbar sublimiert. Ausbeute: 24.9 g (44 mmol), 66.3 % d. Th., Reinheit nach HPLC 99.9 % über alle Isomere, Anteil der cis-isomeren Doppelbindungen im Sublimat ca. 10 %. ³¹P-NMR (Tetrachlorethan-d2): δ [ppm] = -11.3 (s, Hauptpeak, all-trans-Isomer).

### Beispiel 2: Synthese von Tris(4-stilbenyl)phosphinoxid, Dotand D2

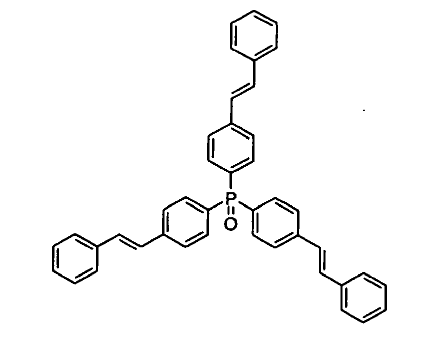

Tris(4-stilbenyl)phosphinoxid wurde nach Xu et al. (J. Organomet. Chem. 2003, 687(2), 301) dargestellt. Der so erhaltene Feststoff wurde viermal aus DMSO (2.5 ml/g) umkristallisiert und dann im Vakuum bei T = 340 °C, p = 5 x 10⁻⁵ mbar sublimiert. Ausbeute bei einem Einsatz von 100 mmol Tris(4-bromphenyl)phosphinoxid: 30.9 g (53 mmol), 52.9 % d. Th., Reinheit nach HPLC 99.9 % über alle Isomere, Anteil der cis-isomeren Doppelbindungen im Sublimat ca. 8 %. ³¹P-NMR (CDCl₃): δ [ppm] = 34.3 (s, Hauptpeak, all-trans-Isomer).

### Beispiel 3: Herstellung der OLEDs

Die Herstellung von OLEDs erfolgte nach einem allgemeinen Verfahren gemäß WO 04/058911, das im Einzelfall auf die jeweiligen Gegebenheiten (z. B. Schichtdickenvariation, um optimale Effizienz bzw. Farbe zu erreichen) angepasst wurde.

In den folgenden Beispielen werden die Ergebnisse verschiedener OLEDs vorgestellt. Der grundlegende Aufbau, die verwendeten Materialien und Schichtdicken, außer der emittierenden Schicht und der Lochtransportschicht, waren zur besseren Vergleichbarkeit identisch. Analog dem o. g. allgemeinen Verfahren wurden OLEDs mit folgendem Aufbau erzeugt:

| | |
|---|---|
| Lochinjektionsschicht (HIL) | 20 nm PEDOT/ PSS (aus wässriger Dispersion aufgeschleudert; bezogen von H. C. Starck, Goslar, Deutschland; Poly(3,4-ethylendioxy-2,5-thiophen)+Polystyrolsulfonsäure) |
| Lochtransportschicht (HTM) | 20 nm NaphDATA (aufgedampft; bezogen von SynTec, Wolfen, Deutschland; 4,4',4"-Tris(N-1-naphthyl-N-phenyl-amino)-triphenylamin), darauf 20 nm S-TAD (aufgedampft; hergestellt nach WO 99/12888; 2,2',7,7'-Tetrakis(diphenylamino)-spiro-9,9'-bifluoren) |
| Emissionschicht (EML) | siehe Tabelle 1 für Materialien, Konzentration und Schichtdicken |
| Elektronenleiter (ETL) | 20 nm Alq₃ (bezogen von SynTec; Tris(chinolinato)aluminium(III)) |
| LiF-Al (Kathode) | 1 nm LiF, darauf 150 nm Al |

Diese noch nicht optimierten OLEDs wurden standardmäßig charakterisiert; hierfür wurden die Elektrolumineszenzspektren, die Effizienz (gemessen in cd/A), die Leistungseffizienz (gemessen in Im/W) in Abhängigkeit der Helligkeit, berechnet aus Strom-Spannungs-Leuchtdichte-Kennlinien (IUL-Kennlinien), und die Lebensdauer bestimmt. Als Lebensdauer wird die Zeit definiert, nach der die Anfangshelligkeit von 250 cd/m² auf die Hälfte gesunken ist.

In Tabelle 1 sind die Ergebnisse einiger OLEDs zusammengefasst, wobei jeweils die Zusammensetzung der EML und der HTL inklusive der Schichtdicken mit aufgeführt ist.

Beispiele 4a und 4b sind Vergleichsbeispiele, die in der Emissionsschicht entweder nur das Hostmaterial **H1** enthalten oder den Dotanden **D3** gemäß dem Stand der Technik dotiert in das Hostmaterial **H1**.

In den erfindungsgemäßen Device-Beispielen 4c - d sind die erfindungsgemäßen Dotanden **D1** und **D2** als emittierende Materialien zusammen mit dem Hostmaterial **H1** in der Emissionsschicht enthalten.

Strukturformeln des verwendeten Vergleichsdotanden und des Hostmaterials:

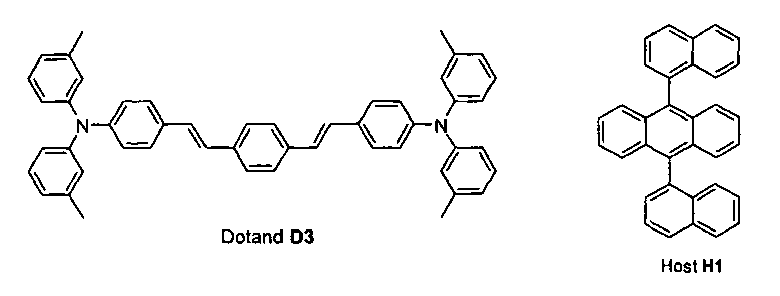

**Tabelle 1**

| Beispiel | EML | Max. Effizienz (cd/A) | Spannung (V) bei 100 cd/m² | CIE^{a} | Lebensdauer (h)^{b} |
|---|---|---|---|---|---|
| **Beispiel 4a** | **H1** | 1.1 | 5.8 | x=0.17 | 1800 |
| (Vergleich) | (30 nm) | | | y=0.19 | |
| **Beispiel 4b** | **H1 : D3** (2 %) | 5.2 | 6.5 | x=0.18 | 4500 |
| (Vergleich) | (30 nm) | | | y=0.34 | |
| | | | | | |
| **Beispiel 4c** | **H1** : **D1** (2 %) | 1.7 | 5.8 | x=0.12 | 1500 |
| | (30 nm) | | | y=0.08 | |
| **Beispiel 4d** | **H1 : D2** (2 %) | 1.5 | 5.5 | x=0.10 | 1350 |
| | (30 nm) | | | y=0.08 | |

| | | | | | |
|---|---|---|---|---|---|
| ^{a} CIE-Koordinaten: Farbkoordinaten der Commision Internationale de l'Eclairage 1931. ^{b} Lebensdauer: Zeit bis zum Abfall der Helligkeit auf 50 % der Anfangshelligkeit, gemessen bei einer Anfangshelligkeit von 250 cd/m². | | | | | |

Zusammenfassend kann gesagt werden, dass OLEDs, enthaltend emittierende Verbindungen **D1** oder **D2,** eine deutlich tiefer blaue Farbe bei weiterhin sehr guter Effizienz und Lebensdauer aufweisen als Materialien gemäß dem Stand der Technik, wie man leicht Tabelle 1 entnehmen kann. Dies ist insbesondere für großformatige Displays, die den NTSC-Farbstandard nutzen, von entscheidender Bedeutung. Daher eignen sich diese Verbindungen besser für die Verwendung in OLEDs als Materialien gemäß dem Stand der Technik.

## Patentansprüche

1. Verwendung von Verbindungen gemäß Formel (1), 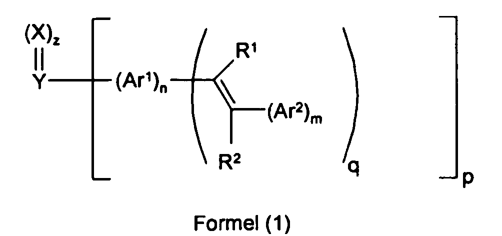 wobei für die verwendeten Symbole und Indizes gilt:
Y ist bei jedem Auftreten Phosphor;
X ist bei jedem Auftreten gleich oder verschieden Sauerstoff, Schwefel oder steht für ein freies Elektronenpaar;
Ar¹ ist bei jedem Auftreten gleich oder verschieden eine Arylgruppe mit 6 bis 16 C-Atomen oder eine Heteroarylgruppe mit 2 bis 16 C-Atomen, die mit einem oder zwei Resten R¹⁰ substituiert sein kann;
Ar² ist bei jedem Auftreten gleich oder verschieden eine Arylgruppe mit 6 bis 16 C-Atomen oder eine Heteroarylgruppe mit 2 bis 16 C-Atomen, die mit einem oder zwei Resten R¹⁰ substituiert sein kann;
R¹, R² ist bei jedem Auftreten gleich oder verschieden H, CN, eine geradkettige Alkylgruppe mit 1 bis 20 C-Atomen oder eine verzweigte Alkylgruppe mit 3 bis 20 C-Atomen, wobei eine oder mehrere nicht benachbarte CH₂-Gruppen durch -R²⁰C=CR²⁰, -C≡C-, -O- oder -S- ersetzt sein können und wobei ein oder mehrere H-Atome durch F ersetzt sein können, oder eine Arylgruppe mit 6 bis 16 C-Atomen oder Heteroarylgruppe mit 2 bis 16 C-Atomen, die mit einem oder mehreren Resten R¹⁰ substituiert sein kann, wobei R¹ bzw. R² jeweils unabhängig voneinander mit dem Rest Ar¹ und/oder Ar² gemeinsam ein cyclisches System bilden können;
R¹⁰ ist bei jedem Auftreten gleich oder verschieden H, F, CN, eine geradkettige Alkyl- oder Alkoxygruppe mit 1 bis 20 C-Atomen, eine verzweigte Alkyl- oder Alkoxygruppe mit 3 bis 20 C-Atomen, eine cyclische Alkyl- oder Alkoxygruppe mit 5 bis 20 C-Atomen, die jeweils mit einem oder mehreren Resten R²⁰ substituiert sein können, wobei eine oder mehrere nicht benachbarte CH₂- Gruppen durch -R²⁰C=CR²⁰, -C≡C, Si(R²⁰)₂, C=O, -O- oder -S- ersetzt sein können und wobei ein oder mehrere H-Atome durch F ersetzt sein können, oder eine Arylgruppe mit 6 bis 16 C-Atomen oder Heteroarylgruppe mit 2 bis 16 C- Atomen, die jeweils durch einen oder mehrere Reste R²⁰ substituiert sein kann, oder eine Aryloxy- oder Heteroaryloxygruppe mit 2 bis 16 aromatischen C- Atomen, die durch einen oder mehrere Reste R²⁰ substituiert sein kann, oder eine Kombination aus zwei, drei, vier oder fünf dieser Systeme; dabei können auch zwei oder mehrere Substituenten R¹⁰ sowohl am selben Ring wie auch an unterschiedlichen Ringen miteinander ein mono- oder polycyclisches, aliphatisches oder aromatisches Ringsystem bilden oder zusammen mit einem Rest R¹ und/oder R² ein Ringsystem bilden;
R²⁰ ist bei jedem Auftreten gleich oder verschieden H oder ein aliphatischer oder aromatischer Kohlenwasserstoffrest mit 1 bis 20 C-Atomen;
n ist bei jedem Auftreten gleich oder verschieden und steht für eine ganze Zahl 1, 2 oder 3;
m ist bei jedem Auftreten gleich 1;
q ist bei jedem Auftreten gleich oder verschieden und steht für eine ganze Zahl 1, 2, 3, 4 oder 5;
p steht für die ganze Zahl 3,
z ist die ganze Zahl 1;
ausgenommen die Verbindung 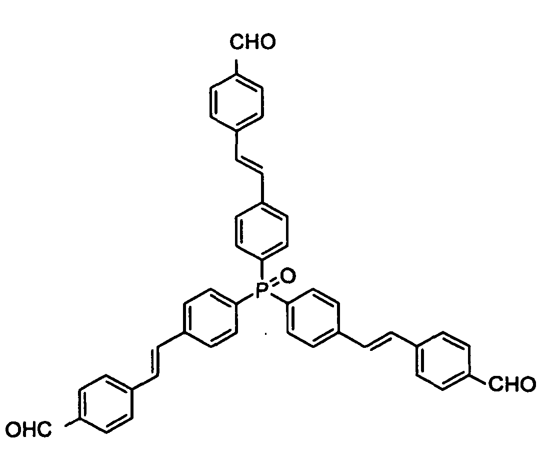 in elektronischen Vorrichtungen.

2. Verwendung gemäß Anspruch 1, **dadurch gekennzeichnet, dass** es sich bei der elektronischen Vorrichtung um organische Leuchtdioden (O-LEDs), organische Feld-Effekt-Transistoren (O-FETs), organische lichtemittierende Transistoren (O-LETs), organische Dünnfilmtransistoren (O-TFTs), organische integrierte Schaltungen (O-ICs), organische Solarzellen (O-SCs), organische Feld-Quench-Devices (O-FQDs) oder organische Laserdioden (O-Laser) handelt.

3. Verwendung gemäß Anspruch 1 und/oder 2, **dadurch gekennzeichnet, dass** die Reste R¹ und R² für H, CN, Methyl, Ethyl, n-Propyl, i- Propyl, n-, sek- oder tert-Butyl, oder eine Phenylgruppe oder eine Heteroarylgruppe mit 4 bis 6 C-Atomen, die jeweils mit einem oder mehreren Resten R¹⁰ substituiert sein kann, stehen und/oder R¹ bzw. R² jeweils unabhängig voneinander mit dem Rest Ar¹ und/oder Ar² gemeinsam ein cyclisches System bilden können.

4. Verwendung gemäß einem oder mehreren der Ansprüche 1 bis 3, **dadurch gekennzeichnet, dass** die Reste Ar¹ und Ar² gleich oder verschieden bei jedem Auftreten für eine Phenylgruppe oder eine Heteroarylgruppe mit 4 bis 6 C-Atomen steht, R¹ und R² gleich oder verschieden bei jedem Auftreten für H, eine geradkettige Alkylgruppe mit 1 bis 10 C-Atomen oder eine verzweigte Alkylgruppe mit 3 bis 4 C-Atomen, wobei eine oder mehrere nicht benachbarte CH₂-Gruppen durch -O- oder -S- ersetzt sein können und wobei ein oder mehrere H-Atome durch F ersetzt sein können und der Rest R¹⁰ bei jedem Auftreten gleich oder verschieden H, F, Br, CN, eine geradkettige Alkylgruppe mit 1 bis 10 C-Atomen, wobei bei der vorstehend genannten Alkylgruppe unabhängig voneinander eine oder mehrere nicht benachbarte CH₂-Gruppen durch -O- oder -S- ersetzt sein können und wobei ein oder mehrere H-Atome durch F, Cl, Br, I, CN oder NO₂ ersetzt sein können,
oder eine Arylgruppe mit 6 bis 14 C-Atomen oder eine Heteroarylgruppe mit 2 bis 10 C-Atomen, welche jeweils durch einen oder mehrere Reste R²⁰ substituiert sein können, oder eine Aryloxygruppe mit 6 bis 10 aromatischen C-Atomen oder eine Heteroaryloxygruppe mit 2 bis 10 aromatischen C-Atomen, die jeweils durch einen oder mehrere Reste R²⁰ substituiert sein kann.

5. Verwendung gemäß einem oder mehreren der Ansprüche 1 bis 4, **dadurch gekennzeichnet, dass** der Index q gleich oder verschieden bei jedem Auftreten für 1, 2 oder 3 steht.

6. Mischungen enthaltend mindestens eine Verbindung gemäß Formel (1), 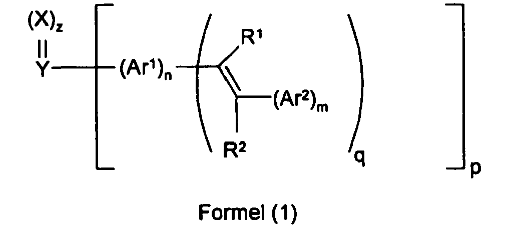 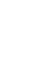 wobei für die verwendeten Symbole und Indizes gilt:
Y ist bei jedem Auftreten Phosphor;
X ist bei jedem Auftreten gleich oder verschieden Sauerstoff, Schwefel, oder steht für ein freies Elektronenpaar;
Ar¹ ist bei jedem Auftreten gleich oder verschieden eine Arylgruppe mit 6 bis 16 C-Atomen oder eine Heteroarylgruppe mit 2 bis 16 C-Atomen, die mit einem oder zwei Resten R¹⁰ substituiert sein kann;
Ar² ist bei jedem Auftreten gleich oder verschieden eine Arylgruppe mit 6 bis 16 C-Atomen oder eine Heteroarylgruppe mit 2 bis 16 C-Atomen, die mit einem oder zwei Resten R¹⁰ substituiert sein kann;
R¹, R² ist bei jedem Auftreten gleich oder verschieden H, CN, eine geradkettige Alkylgruppe mit 1 bis 20 C-Atomen oder eine verzweigte Alkylgruppe mit 3 bis 20 C-Atomen, wobei eine oder mehrere nicht benachbarte CH₂-Gruppen durch -R²⁰C=CR²⁰-, -C≡C-, -O- oder -S- ersetzt sein können und wobei ein oder mehrere H-Atome durch F ersetzt sein können, oder eine Arylgruppe mit 6 bis 16 C-Atomen oder Heteroarylgruppe mit 2 bis 16 C-Atomen, die mit einem oder mehreren Resten R¹⁰ substituiert sein kann, und R¹ bzw. R² können jeweils unabhängig voneinander mit dem Rest Ar¹ und/oder Ar² gemeinsam ein cyclisches System bilden ;
R¹⁰ ist bei jedem Auftreten gleich oder verschieden H, F, CN, eine geradkettige Alkyl- oder Alkoxygruppe mit 1 bis 20 C-Atomen, eine verzweigte Alkyl- oder Alkoxygruppe mit 3 bis 20 C-Atomen, eine cyclische Alkyl- oder Alkoxygruppe mit 5 bis 20 C-Atomen, die jeweils mit einem oder mehreren Resten R²⁰ substituiert sein können, wobei eine oder mehrere nicht benachbarte CH₂- Gruppen durch -R²⁰C=CR²⁰-, -C≡C-, Si(R²⁰)₂, C=O, -O- oder -S- ersetzt sein können und wobei ein oder mehrere H-Atome durch F ersetzt sein können, oder eine Arylgruppe mit 6 bis 16 C-Atomen oder Heteroarylgruppe mit 2 bis 16 C- Atomen, die jeweils durch einen oder mehrere Reste R²⁰ substituiert sein kann, oder eine Aryloxy- oder Heteroaryloxygruppe mit 2 bis 16 aromatischen C- Atomen, die durch einen oder mehrere Reste R²⁰ substituiert sein kann, oder eine Kombination aus zwei, drei, vier oder fünf dieser Systeme; dabei können auch zwei oder mehrere Substituenten R¹⁰ sowohl am selben Ring wie auch an unterschiedlichen Ringen miteinander ein mono- oder polycyclisches, aliphatisches oder aromatisches Ringsystem bilden oder zusammen mit einem Rest R¹ und/oder R² ein Ringsystem bilden ;
R²⁰ ist bei jedem Auftreten gleich oder verschieden H oder ein aliphatischer oder aromatischer Kohlenwasserstoffrest mit 1 bis 20 C-Atomen;
n ist bei jedem Auftreten gleich oder verschieden und steht für eine ganze Zahl 1, 2 oder 3;
m ist bei jedem Auftreten gleich 1;
q ist bei jedem Auftreten gleich oder verschieden und steht für eine ganze Zahl 1, 2, 3, 4 oder 5;
p steht für die ganze Zahl 3,
z ist die ganze Zahl 1;
und
mindestens ein Hostmaterial, welches ausgewählt ist aus Oligoarylenen, Oligoarylenvinylenen, polypodalen Metallkomplexen, Ketonen, Phosphinoxiden, Sulfoxiden oder Atropisomeren dieser Verbindungen.

7. Mischungen gemäß Anspruch 6, enthaltend **dadurch gekennzeichnet, dass** als der Anteil der Verbindung gemäß Formel (1) in der Mischung zwischen 0.1 und 99.0 Gew.% beträgt.

8. Mischungen gemäß einem oder mehreren der Ansprüche 6 bis 7, **dadurch gekennzeichnet, dass** der Anteil des Hostmaterials in der Mischung zwischen 1.0 und 99.9 Gew.% beträgt.

9. Konjugierte, teilkonjugierte oder nicht-konjugierte Polymere, Oligomere oder Dendrimere, enthaltend Wiederholeinheiten gemäß Formel (1) gemäß einem oder mehreren der Ansprüche 1 bis 5.

10. Verwendung von Polymeren gemäß Anspruch 9 in organischen elektronischen Vorrichtungen.

11. Elektronische Vorrichtung enthaltend mindestens eine Verbindung gemäß Anspruch 1 bis 5 und/oder eine Mischung gemäß Anspruch 6 bis 8 und/oder ein Polymer gemäß Anspruch 9.

12. Elektronische Vorrichtung gemäß Anspruch 11, **dadurch gekennzeichnet, dass** es sich bei der elektronischen Vorrichtung um organische Leuchtdioden (O-LEDs), organische Feld-Effekt-Transistoren (O-FETs), organische lichtemittierende Transistoren (O-LETs), organische Dünnfilmtransistoren (O-TFTs), organische integrierte Schaltungen (O-ICs), organische Solarzellen (O-SCs), organische Feld-Quench-Devices (O-FQDs) oder organische Laserdioden (O-Laser) handelt.

## Claims

1. Use of compounds of the formula (1), 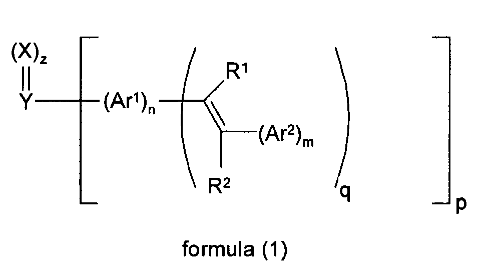 where the following applies to the symbols and indices used:
Y is on each occurrence phosphorus;
X is on each occurrence, identically or differently, oxygen, sulfur or stands for a free electron pair;
Ar¹ is on each occurrence, identically or differently, an aryl group having 6 to 16 C atoms or a heteroaryl group having 2 to 16 C atoms, which may be substituted by one or two radicals R¹⁰;
Ar² is on each occurrence, identically or differently, an aryl group having 6 to 16 C atoms or a heteroaryl group having 2 to 16 C atoms, which may be substituted by one or two radicals R¹⁰;
R¹, R² are on each occurrence, identically or differently, H, CN, a straight-chain alkyl group having 1 to 20 C atoms or a branched alkyl group having 3 to 20 C atoms, where one or more non-adjacent CH₂ groups may be replaced by -R²⁰C=CR²⁰-, -C≡C-, -O- or -S- and where one or more H atoms may be replaced by F, or an aryl group having 6 to 16 C atoms or a heteroaryl group having 2 to 16 C atoms, which may be substituted by one or more radicals R¹⁰, where R¹ and/or R² may each, independently of one another, form a cyclic sys- tem together with the radical Ar¹ and/or Ar² respectively;
R¹⁰ is on each occurrence, identically or differently, H, F, CN, a straight-chain alkyl or alkoxy group having 1 to 20 C atoms, a branched alkyl or alkoxy group hav- ing 3 to 20 C atoms, a cyclic alkyl or alkoxy group having 5 to 20 C atoms, each of which may be substituted by one or more radicals R²⁰, where one or more non-adjacent CH₂ groups may be replaced by -R²⁰C=CR²⁰-, -C≡C-, Si(R²⁰)₂, C=O, -O- or -S- and where one or more H atoms may be replaced by F, or an aryl group having 6 to 16 C atoms or a heteroaryl group having 2 to 16 C atoms, each of which may be substituted by one or more radicals R²⁰, or an aryloxy or heteroaryloxy group having 2 to 16 aromatic C atoms, which may be substituted by one or more radicals R²⁰, or a combination of two, three, four or five of these systems; two or more substituents R¹⁰ here, both on the same ring and also on different rings, may also form a mono- or polycyclic, aliphatic or aromatic ring system with one another or may form a ring system together with a radical R¹ and/or R²;
R²⁰ is on each occurrence, identically or differently, H or an aliphatic or aromatic hydrocarbon radical having 1 to 20 C atoms;
n is identical or different on each occurrence and stands for an integer 1, 2 or 3;
m is on each occurrence equal to 1;
q is identical or different on each occurrence and stands for an integer 1, 2, 3, 4 or 5;
p stands for the integer 3;
z is the integer 1;
with the exception of the compound 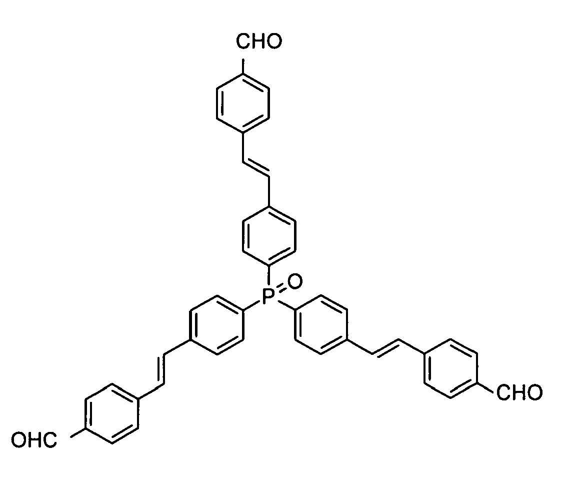 in electronic devices.

2. Use according to Claim 1, **characterised in that** the electronic devices are organic light-emitting diodes (O-LEDs), organic field-effect transistors (O-FETs), organic light-emitting transistors (O-LETs), organic thin-film transistors (O-TFTs), organic integrated circuits (O-ICs), organic solar cells (O-SCs), organic field-quench devices (O-FQDs) or organic laser diodes (O-lasers).

3. Use according to Claim 1 and/or 2, **characterised in that** the radicals R¹ and R² stand for H, CN, methyl, ethyl, n-propyl, i-propyl, n-, sec- or tert-butyl, or a phenyl group or heteroaryl group having 4 to 6 C atoms, each of which may be substituted by one or more radicals R¹⁰, and/or R¹ and/or R² may each, independently of one another, form a cyclic system together with the radical Ar¹ and/or Ar² respectively.

4. Use according to one or more of Claims 1 to 3, **characterised in that** the radicals Ar¹ and Ar² stand, identically or differently on each occurrence, for a phenyl group or heteroaryl group having 4 to 6 C atoms, R¹ and R² stand, identically or differently on each occurrence, for H, a straight-chain alkyl group having 1 to 10 C atoms or a branched alkyl group having 3 to 4 C atoms, where one or more non-adjacent CH₂ groups may be replaced by -O- or -S- and where one or more H atoms may be replaced by F, and the radical R¹⁰ on each occurrence, identically or differently, denotes H, F, Br, CN, a straight-chain alkyl group having 1 to 10 C atoms, where one or more non-adjacent CH₂ groups in the above-mentioned alkyl group may be replaced, independently of one another, by -O- or -S- and where one or more H atoms may be replaced by F, Cl, Br, I, CN or NO₂ or an aryl group having 6 to 14 C atoms or a heteroaryl group having 2 to 10 C atoms, each of which may be substituted by one or more radicals R²⁰, or an aryloxy group having 6 to 10 aromatic C atoms or a heteroaryloxy group having 2 to 10 aromatic C atoms, each of which may be substituted by one or more radicals R²⁰.

5. Use according to one or more of Claims 1 to 4, **characterised in that** the index q stands, identically or differently on each occurrence, for 1, 2 or 3.

6. Mixtures comprising at least one compound of the formula (1), 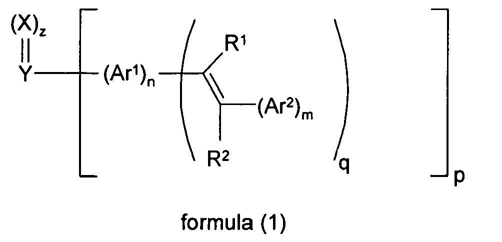 where the following applies to the symbols and indices used:
Y is on each occurrence phosphorus;
X is on each occurrence, identically or differently, oxygen, sulfur or stands for a free electron pair;
Ar¹ is on each occurrence, identically or differently, an aryl group having 6 to 16 C atoms or a heteroaryl group having 2 to 16 C atoms, which may be substituted by one or two radicals R¹⁰;
Ar² is on each occurrence, identically or differently, an aryl group having 6 to 16 C atoms or a heteroaryl group having 2 to 16 C atoms, which may be substituted by one or two radicals R¹⁰;
R¹, R² are on each occurrence, identically or differently, H, CN, a straight-chain alkyl group having 1 to 20 C atoms or a branched alkyl group having 3 to 20 C atoms, where one or more non-adjacent CH₂ groups may be replaced by -R²⁰C=CR²⁰-, -C=C-, -O- or -S- and where one or more H atoms may be replaced by F, or an aryl group having 6 to 16 C atoms or a heteroaryl group having 2 to 16 C atoms, which may be substituted by one or more radicals R¹⁰ and where R¹ and/or R² may each, independently of one another, form a cyclic system together with the radical Ar¹ and/or Ar² respectively;
R¹⁰ is on each occurrence, identically or differently, H, F, CN, a straight-chain alkyl or alkoxy group having 1 to 20 C atoms, a branched alkyl or alkoxy group hav- ing 3 to 20 C atoms, a cyclic alkyl or alkoxy group having 5 to 20 C atoms, each of which may be substituted by one or more radicals R²⁰, where one or more non-adjacent CH₂ groups may be replaced by -R²⁰C=CR²⁰-, -C≡C-, Si(R²⁰)₂, C=O, -O- or -S- and where one or more H atoms may be replaced by F, or an aryl group having 6 to 16 C atoms or a heteroaryl group having 2 to 16 C atoms, each of which may be substituted by one or more radicals R²⁰, or an aryloxy or heteroaryloxy group having 2 to 16 aromatic C atoms, which may be substituted by one or more radicals R²⁰, or a combination of two, three, four or five of these systems; two or more substituents R¹⁰ here, both on the same ring and also on different rings, may also form a mono- or polycyclic, aliphatic or aromatic ring system with one another or may form a ring system together with a radical R¹ and/or R²;
R²⁰ is on each occurrence, identically or differently, H or an aliphatic or aromatic hydrocarbon radical having 1 to 20 C atoms;
n is identical or different on each occurrence and stands for an integer 1, 2 or 3;
m is on each occurrence equal to 1;
q is identical or different on each occurrence and stands for an integer 1, 2, 3, 4 or 5;
p stands for the integer 3;
z is the integer 1;
and
at least one host material selected from oligoarylenes, oligoarylenevinylenes, polypodal metal complexes, ketones, phosphine oxides, sulfoxides or atropisomers of these compounds.

7. Mixtures according to Claim 6, **characterised in that** the proportion of the compound of the formula (1) in the mixture is between 0.1 and 99.0% by weight.

8. Mixtures according to one or more of Claims 6 to 7, **characterised in that** the proportion of the host material in the mixture is between 1.0 and 99.9% by weight.

9. Conjugated, partially conjugated or non-conjugated polymers, oligomers or dendrimers containing recurring units of the formula (1) according to one or more of Claims 1 to 5.

10. Use of polymers according to Claim 9 in organic electronic devices.

11. Electronic device comprising at least one compound according to Claims 1 to 5 and/or a mixture according to Claims 6 to 8 and/or a polymer according to Claim 9.

12. Electronic device according to Claim 11, **characterised in that** the electronic device comprises organic light-emitting diodes (O-LEDs), organic field-effect transistors (O-FETs), organic light-emitting transistors (O-LETs), organic thin-film transistors (O-TFTs), organic integrated circuits (O-ICs), organic solar cells (O-SCs), organic field-quench devices (O-FQDs) or organic laser diodes (O-lasers).

## Revendications

1. Utilisation de composés de la formule (1), 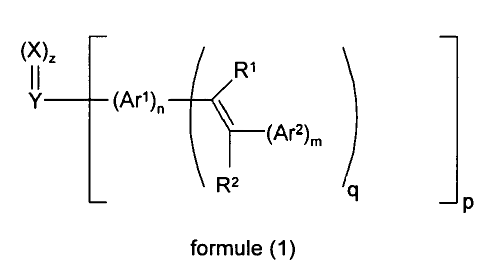 dans laquelle ce qui suit s'applique aux symboles et indices utilisés :
Y est à chaque occurrence phosphore ;
X est à chaque occurrence, de façon identique ou différente, oxygène, soufre ou représente une paire d'électrons libres ;
Ar¹ est à chaque occurrence, de façon identique ou différente, un groupe aryle ayant 6 à 16 atomes de C ou un groupe hétéroaryle ayant 2 à 16 atomes de C, qui peut être substitué par un ou deux radicaux R¹⁰ ;
Ar² est à chaque occurrence, de façon identique ou différente, un groupe aryle ayant 6 à 16 atomes de C ou un groupe hétéroaryle ayant 2 à 16 atomes de C, qui peut être substitué par un ou deux radicaux R¹⁰ ;
R¹, R² sont à chaque occurrence, de façon identique ou différente, H, CN, un groupe alkyle en chaîne droite ayant 1 à 20 atomes de C ou un groupe alkyle ramifié ayant 3 à 20 atomes de C, dans lequel un ou plusieurs groupes CH₂ non adja- cents peuvent être remplacés par -R²⁰C=CR²⁰-, -C=C-, -O- ou -S- et dans lequel un ou plusieurs atomes de H peuvent être remplacés par F, ou un groupe aryle ayant 6 à 16 atomes de C ou un groupe hétéroaryle ayant 2 à 16 atomes de C, qui peut être substitué par un ou plusieurs radicaux R¹⁰, dans lequel R¹ et/ou R² peuvent chacun, indépendamment l'un de l'autre, former un système cyclique ensemble avec respectivement le radical Ar¹ et/ou Ar² ;
R¹⁰ est à chaque occurrence, de façon identique ou différente, H, F, CN, un groupe alkyle ou alcoxy en chaîne droite ayant 1 à 20 atomes de C, un groupe alkyle ou alcoxy ramifié ayant 3 à 20 atomes de C, un groupe alkyle ou alcoxy cycli- que ayant 5 à 20 atomes de C, dont chacun peut être substitué par un ou plu- sieurs radicaux R²⁰, dans lequel un ou plusieurs groupes CH₂ non adjacents peuvent être remplacés par -R²⁰C=CR²¹-, -C≡C-, Si(R²⁰)₂, C=O, -O- ou -S- et dans lequel un ou plusieurs atomes de H peuvent être remplacés par F, ou un groupe aryle ayant 6 à 16 atomes de C ou un groupe hétéroaryle ayant 2 à 16 atomes de C, dont chacun peut être substitué par un ou plusieurs radicaux R²⁰, ou un groupe aryloxy ou hétéroaryloxy ayant 2 à 16 atomes de C aromatiques, qui peut être substitué par un ou plusieurs radicaux R²⁰, ou une combinaison de deux, trois, quatre ou cinq de ces systèmes ; deux substituants R¹⁰ ou plus ici, à la fois sur le même cycle et aussi sur des cycles différents, peuvent également former un système de cycle aliphatique ou aromatique mono- ou polycyclique avec un autre ou peuvent former un système de cycle ensemble avec un radical R¹ et/ou R² ;
R²⁰ est à chaque occurrence, de façon identique ou différente, H ou un radical hydrocarbone aliphatique ou aromatique ayant 1 à 20 atomes de C ;
n est identique ou différent à chaque occurrence et représente un entier 1, 2 ou 3 ;
m est à chaque occurrence égal à 1 ;
q est identique ou différent à chaque occurrence et représente un entier 1, 2, 3, 4 ou 5 ;
p représente l'entier 3 ;
z est l'entier 1 ;
à l'exception du composé 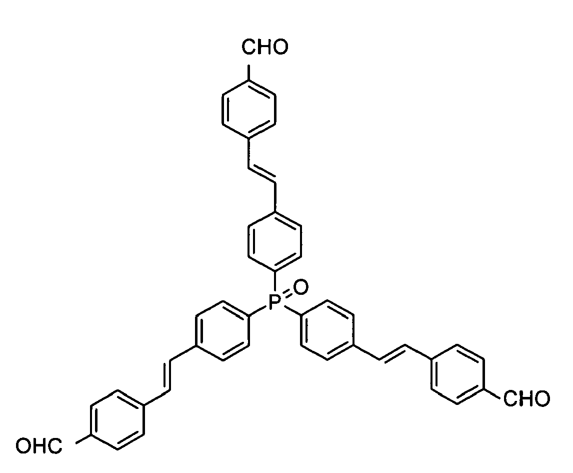 dans des dispositifs électroniques.

2. Utilisation selon la revendication 1, **caractérisée en ce que** les dispositifs électroniques sont des diodes émettrices de lumière organiques (O-LEDs), transistors à effet de champ organiques (O-FETs), transistors émetteurs de lumière organiques (O-LETs), transistors à film mince organiques (O-TFTs), circuits intégrés organiques (O-ICs), cellules solaires organiques (O-SCs), dispositifs à pincement de champ organiques (O-FQDs) ou diodes laser organiques (O-lasers).

3. Utilisation selon la revendication 1 et/ou 2, **caractérisée en ce que** les radicaux R¹ et R² représentent H, CN, méthyle, éthyle, n-propyle, i-propyle, n-, sec- ou tertbutyle, ou un groupe phényle ou un groupe hétéroaryle ayant 4 à 6 atomes de C, dont chacun peut être substitué par un ou plusieurs radicaux R¹⁰, et/ou R¹ et/ou R² peuvent chacun, indépendamment l'un de l'autre, former un système cyclique ensemble avec respectivement le radical Ar¹ et/ou Ar².

4. Utilisation selon une ou plusieurs des revendications 1 à 3, **caractérisée en ce que** les radicaux Ar¹ et Ar² représentent, de façon identique ou différente à chaque occurrence, un groupe phényle ou un groupe hétéroaryle ayant 4 à 6 atomes de C, R¹ et R² représentent, de façon identique ou différente à chaque occurrence, H, un groupe alkyle en chaîne droite ayant 1 à 10 atomes de C ou un groupe alkyle ramifié ayant 3 à 4 atomes de C, dans lequel un ou plusieurs groupes CH₂ non adjacents peuvent être remplacés par -O- ou -S- et dans lequel un ou plusieurs atomes de H peuvent être remplacés par F, et le radical R¹⁰ à chaque occurrence, de façon identique ou différente, représente H, F, Br, CN, un groupe alkyle en chaîne droite ayant 1 à 10 atomes de C, dans lequel un ou plusieurs groupes CH₂ non adjacents dans le groupe alkyle mentionné ci-avant peuvent être remplacés, indépendamment l'un de l'autre, par -O- ou -S- et dans lequel un ou plusieurs atomes de H peuvent être remplacés par F, Cl, Br, I, CN ou NO₂, ou un groupe aryle ayant 6 à 14 atomes de C ou un groupe hétéroaryle ayant 2 à 10 atomes de C, dont chacun peut être substitué par un ou plusieurs radicaux R²⁰, ou un groupe aryloxy ayant 6 à 10 atomes de C aromatiques ou un groupe hétéroaryloxy ayant 2 à 10 atomes de C aromatiques, dont chacun peut être substitué par un ou plusieurs radicaux R²⁰.

5. Utilisation selon une ou plusieurs des revendications 1 à 4, **caractérisée en ce que** l'indice q représente, de façon identique ou différente à chaque occurrence, 1, 2 ou 3.

6. Mélanges comprenant au moins un composé de la formule (1), 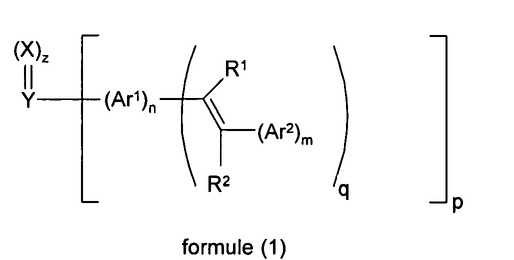 dans laquelle ce qui suit s'applique aux symboles et indices utilisés :
Y est à chaque occurrence phosphore ;
X est à chaque occurrence, de façon identique ou différente, oxygène, soufre ou représente une paire d'électrons libres ;
Ar¹ est à chaque occurrence, de façon identique ou différente, un groupe aryle ayant 6 à 16 atomes de C ou un groupe hétéroaryle ayant 2 à 16 atomes de C, qui peut être substitué par un ou deux radicaux R¹⁰ ;
Ar² est à chaque occurrence, de façon identique ou différente, un groupe aryle ayant 6 à 16 atomes de C ou un groupe hétéroaryle ayant 2 à 16 atomes de C, qui peut être substitué par un ou deux radicaux R¹⁰ ;
R¹, R² sont à chaque occurrence, de façon identique ou différente, H, CN, un groupe alkyle en chaîne droite ayant 1 à 20 atomes de C ou un groupe alkyle ramifié ayant 3 à 20 atomes de C, dans lequel un ou plusieurs groupes CH₂ non adja- cents peuvent être remplacés par -R²⁰C=CR²⁰-, -C=C-, -O- ou -S- et dans lequel un ou plusieurs atomes de H peuvent être remplacés par F, ou un groupe aryle ayant 6 à 16 atomes de C ou un groupe hétéroaryle ayant 2 à 16 atomes de C, qui peut être substitué par un ou plusieurs radicaux R¹⁰ et dans lequel R¹ et/ou R² peuvent chacun, indépendamment l'un de l'autre, former un système de cycle ensemble avec respectivement le radical Ar¹ et/ou Ar² ;
R¹⁰ est à chaque occurrence, de façon identique ou différente, H, F, CN, un groupe alkyle ou alcoxy en chaîne droite ayant 1 à 20 atomes de C, un groupe alkyle ou alcoxy ramifié ayant 3 à 20 atomes de C, un groupe alkyle ou alcoxy cycli- que ayant 5 à 20 atomes de C, dont chacun peut être substitué par un ou plu- sieurs radicaux R²⁰, dans lequel un ou plusieurs groupes CH₂ non adjacents peuvent être remplacés par -R²⁰C=CR²⁰-, -C≡C-, Si(R²⁰)₂, C=O, -O- ou -S- et dans lequel un ou plusieurs atomes de H peuvent être remplacés par F, ou un groupe aryle ayant 6 à 16 atomes de C ou un groupe hétéroaryle ayant 2 à 16 atomes de C, dont chacun peut être substitué par un ou plusieurs radicaux R²⁰, ou un groupe aryloxy ou hétéroaryloxy ayant 2 à 16 atomes de C aromatiques, qui peut être substitué par un ou plusieurs radicaux R²⁰, ou une combinaison de deux, trois, quatre ou cinq de ces systèmes ; deux substituants R¹⁰ ou plus ici, à la fois sur le même cycle et aussi sur des cycles différents, peuvent également former un système de cycle aliphatique ou aromatique mono- ou polycyclique avec un autre ou peuvent former un système de cycle ensemble avec un radical R¹ et/ou R² ;
R²⁰ est à chaque occurrence, de façon identique ou différente, H ou un radical hydrocarbone aliphatique ou aromatique ayant 1 à 20 atomes de C ;
n est identique ou différent à chaque occurrence et représente un entier 1, 2 ou 3 ;
m est à chaque occurrence égal à 1 ;
q est identique ou différent à chaque occurrence et représente un entier 1, 2, 3, 4 ou 5 ;
p représente l'entier 3 ;
z est l'entier 1 ;
et
au moins un matériau hôte choisi parmi oligoarylènes, oligoarylènevinylènes, complexes de métal polypodal, cétones, oxydes de phosphine, sulfoxydes ou atropisomères de ces composés.

7. Mélanges selon la revendication 6, **caractérisés en ce que** la proportion du composé de la formule (1) dans le mélange est entre 0,1 et 99,0% en poids.

8. Mélanges selon une ou plusieurs des revendications 6 à 7, **caractérisés en ce que** la proportion du matériau hôte dans le mélange est entre 1,0 et 99,9% en poids.

9. Polymères, oligomères ou dendrimères conjugués, partiellement conjugués ou non conjugués contenant des unités récurrentes de la formule (1) selon une ou plusieurs des revendications 1 à 5.

10. Utilisation des polymères selon la revendication 9 dans des dispositifs électroniques organiques.

11. Dispositif électronique comprenant au moins un composé selon les revendications 1 à 5 et/ou un mélange selon les revendications 6 à 8 et/ou un polymère selon la revendication 9.

12. Dispositif électronique selon la revendication 11, **caractérisé en ce que** le dispositif électronique comprend des diodes émettrices de lumière organiques (O-LEDs), transistors à effet de champ organiques (O-FETs), transistors émetteurs de lumière organiques (O-LETs), transistors à film mince organiques (O-TFTs), circuits intégrés organiques (O-ICs), cellules solaires organiques (O-SCs), dispositifs à pincement de champ organiques (0-FQDs) ou diodes laser organiques (O-lasers).
